Europäisches Patentamt

European Patent Office

Office européen des brevets

(19)

(11) EP 0 899 866 A1

(12) **EUROPEAN PATENT APPLICATION**

(43) Date of publication:
03.03.1999 Bulletin 1999/09

(51) Int. Cl.$^6$: **H03B 5/12**

(21) Application number: 98115451.1

(22) Date of filing: 17.08.1998

(84) Designated Contracting States:
AT BE CH CY DE DK ES FI FR GB GR IE IT LI LU
MC NL PT SE
Designated Extension States:
AL LT LV MK RO SI

(30) Priority: 27.08.1997 US 919141

(71) Applicant: LSI LOGIC CORPORATION
Milpitas, CA 95035 (US)

(72) Inventors:
• Kyles, Ian
  West Linn, Oregon 97068 (US)
• Lim, Richard Wei Tjan
  Portland, Oregon 97223 (US)

(74) Representative:
Kirschner, Klaus Dieter, Dipl.-Phys.
Patentanwalt,
Sollner Strasse 38
81479 München (DE)

(54) **Reactive tuned oscillator using standard CMOS technology**

(57) An oscillator (200) is shown which utilizes non-linear MOSFET varactors (212, 214) along with inductors ($L_1$, $L_2$) to control the frequency of oscillation. The MOSFET varactors are coupled in series with each other between the outputs of a differential amplifier (216, 218). The inductors are also coupled in series with each other between the outputs of the differential amplifier. The capacitance of the MOSFET varactors, and therefore the oscillating frequency of the oscillator, is controlled by a tuning voltage applied to a common node (TUNE) of the MOSFET varactors.

EP 0 899 866 A1

## Description

### BACKGROUND OF THE INVENTION

This invention relates generally to the provision of a clocking signal in a communications transceiver.

Digital data are often transferred across computer and telecommunications networks. A clock signal is required to synchronize both the transmission and reception of digital data in a communications device used to transfer the data. The clock signal is used by a transmitter to drive digital data onto a communications medium at a set frequency. The clock signal is used by a receiver to recover the transmitted data from the communications medium and drive the circuits which receive the data from the receiver.

Clock signals having high precision are desirable in order to transmit and receive without losing data. A precise transmit clock aids in the efficient and loss-free reception of the transmitted data because the data transmitted using the clock has a predictable transfer frequency with consistent data transition edge positions. Data transmitted using a transmit clock having jitter, i.e. random or systematic variation in an edge position relative to an ideal edge, or that is out-of-tolerance, i.e. the fundamental frequency of the data signal deviates from the ideal frequency, must be compensated for in the receiver and, if the receiver is unable to compensate then data can be lost. Thus, receivers require precise clocks that allow the receiver to compensate for differences in the phase and frequency of the incoming data.

It is therefore an advantage to produce a clock signal using an oscillator having low intrinsic noise and stable oscillation frequency over a variety of processes, supply voltages and temperature ranges. An inductance-capacitance (LC) oscillator features these advantages because the narrow band filtering obtained with the LC oscillator removes much of the intrinsic noise. Also, the oscillation frequency $F_0 = 1/(2\partial\_LC)$, being a function of inductance L, which is determined by large-scale geometries or a metal coil, and capacitance C, which is determined by well-controlled oxide thickness levels and capacitor area, varies little with processing, supply voltage or temperature changes.

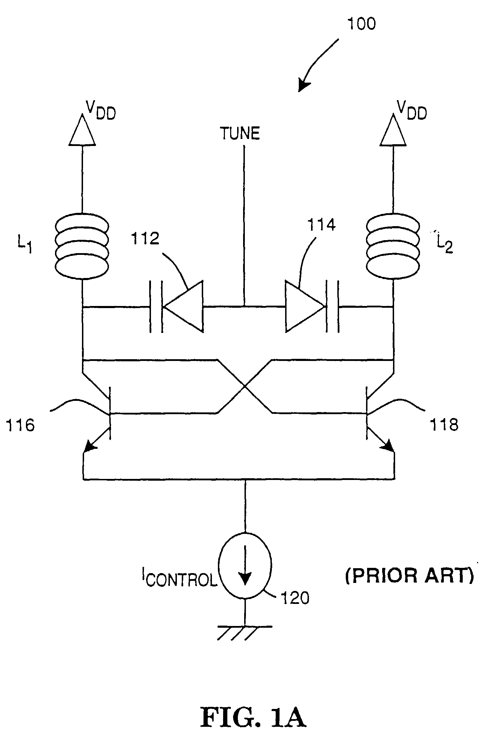

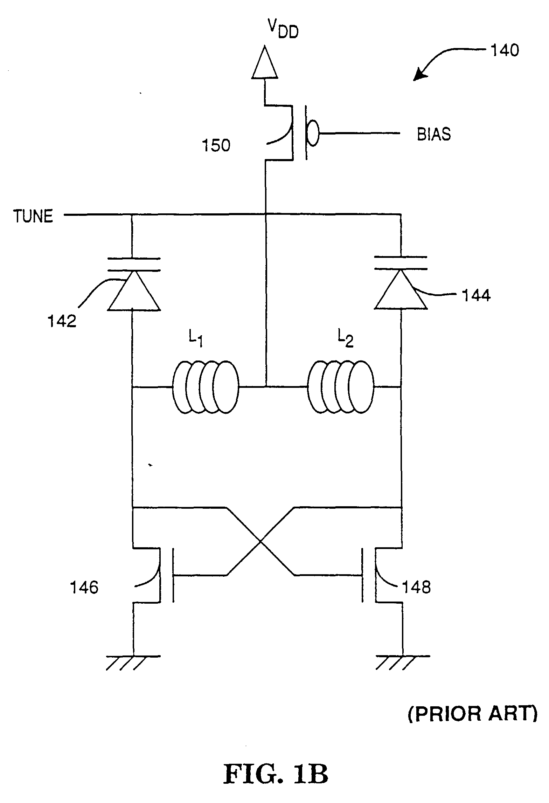

However, in prior art devices such as that shown in FIGS. 1A and 1B, either p-n junctions or Schottky junctions in reverse-bias are used as variable capacitors (varactors). In FIG. 1A, an oscillator 100 according to the prior art is composed of a pair of p-n or Schottky junctions 112 and 114 which are used as varactors. Cross-coupled transistors 116 and 118 are connected in series with inductors $L_1$ and $L_2$, respectively. The anodes of varactors 112 and 114 are connected to the collectors of transistors 116 and 118, respectively. A current source 120 maintains a control current $I_{CONTROL}$ which determines the bias level of the transistors. The cathodes of varactors 112 and 114 are coupled to a TUNE terminal which is driven by a signal which varies the capacitance of the reverse-biased junctions of the varactors.

In FIG. 1B, another oscillator 140 according to the prior art is composed of a pair of p-n or Schottky junctions 142 and 144 used as varactors. The anodes of varactors 142 and 144 are coupled to a TUNE terminal which is driven by a signal which varies the capacitance of the reverse-biased junctions of the varactors. The cathodes of varactors 142 and 144 are connected to the drain terminals of cross-coupled transistors 146 and 148, respectively. Inductors $L_1$ and $L_2$ are connected in series between the drains terminals of transistors 146 and 148. Transistor 150 is driven by a signal applied to a BIAS terminal to source a biasing current which flows into the circuit through the common terminal of inductors $L_1$ and $L_2$ which is connected to the source terminal of transistor 150. Oscillator 140 is described in further detail in "A 1.8-GHz Low-Phase-Noise CMOS VCO Using Optimized Hollow Spiral Inductors", pp. 736-744, IEEE Journal of Solid-State Circuit, Vol. 32, No. 5, May 1997, which also describes the fabrication of silicon integrated inductors.

Because oscillator 140 has no automatic gain control (AGC) and because of the presence of inductors $L_1$ and $L_2$ in the circuit, the output voltages of the differential amplifier formed by transistors 146 and 148, i.e. the voltages at the drains terminals of transistors 146 and 148, can swing below the ground potential at the source terminals of transistors 146 and 148 while the circuit is oscillating. Furthermore, oscillator 140 has no selectable tuning ranges. Therefore, the tuning range responsive to the voltage signal applied to the TUNE terminal must be large enough to accommodate process and temperature variations which means greater gain for the signal and, consequently, greater noise injection effects.

Still further, in standard complementary metal-oxide semiconductor (CMOS) processes, the p-n and Schottky junctions typically used for oscillators are not well characterized and are typically doped too heavily to give much variation in reverse-biased junction capacitance resulting in reduced tunability. Leakage current, which upsets the voltage signal applied to the TUNE terminal used to tune the oscillator, may also be a problem with these prior art p-n junction devices.

Accordingly, the need remains for an oscillator constructed with varactors which are well-characterized for fabrication using MOS processes, have a high degree of capacitance variance, and possess low leakage current.

### SUMMARY OF THE INVENTION

It is, therefore, an object of the invention to provide an oscillator which uses MOSFET devices for variable capacitors that are easily fabricated using well understood fabrication processes and have low leakage current, low intrinsic noise, and stable oscillation frequency over a variety of processes, supply voltages and temperature ranges.

It is a further object of the present invention to provide an oscillator that is easily adapted to a variety of operating frequencies using MOSFET varactors with reduced gain to avoid noise injection effects.

An embodiment of an oscillator circuit according to the present invention includes a differential amplifier having first and second signal terminals and a current terminal, a current source coupled between the current terminal of the differential amplifier and a first power supply terminal and configured to conduct a control current, first and second inductors coupled in series with one another between the first and second signal terminals of the differential amplifier, first and second MOSFET varactors coupled in series with one another to form a pair of varactors that is coupled between the first and second signal terminals of the differential amplifier and where a common node of the pair of varactors is coupled to a tune terminal.

An embodiment of a method for generating an oscillating signal according to the present invention includes amplifying the oscillating signal by a gain value in an amplifier, positively feeding back the oscillating signal from an output of the amplifier to an input of the amplifier, controlling a frequency of the oscillating signal using inductors and non-linear MOSFET varactors, and adjusting the capacitance of the non-linear MOSFET varactors responsive to a frequency tuning signal.

The foregoing and other objects, features and advantages of the invention will become more readily apparent from the following detailed description of a preferred embodiment of the invention which proceeds with reference to the accompanying drawings.

BRIEF DESCRIPTION OF THE DRAWINGS

FIG. 1A is a circuit diagram of a prior art oscillator using p-n or Schottky junctions as varactors.
FIG. 1B is a circuit diagram of another prior art oscillator using p-n or Schottky junctions as varactors.
FIG. 2 is a circuit diagram of an embodiment of an NMOS oscillator using non-linear variable capacitors according to the present invention.
FIG. 3 is a circuit diagram of an embodiment of a PMOS oscillator using non-linear variable capacitors according to the present invention.
FIG. 4 is a circuit diagram of an embodiment of a CMOS oscillator using non-linear variable capacitors according to the present invention.
FIG. 5A is a circuit diagram of the non-linear variable capacitor used in the circuits of FIGS. 2-4 and 7.
FIG. 5B is a plot of the capacitance of the non-linear variable capacitor of FIG. 5 as a function of the junction voltage across the variable capacitor.
FIG. 6A is a waveform diagram illustrating an example of the oscillation of the circuits of FIGS. 2-4 and 7 relative to the capacitance tuning voltage level.
FIG. 6B is a graph which illustrates the change in capacitance of the variable capacitor of FIG. 5A responsive to the waveform of FIG. 6A.
FIG. 7 is a circuit diagram of an embodiment of an oscillator according to the present invention which includes range control.
FIG. 8 is a circuit diagram of an embodiment of range select circuit for the oscillator of FIG. 7.

DETAILED DESCRIPTION OF THE INVENTION

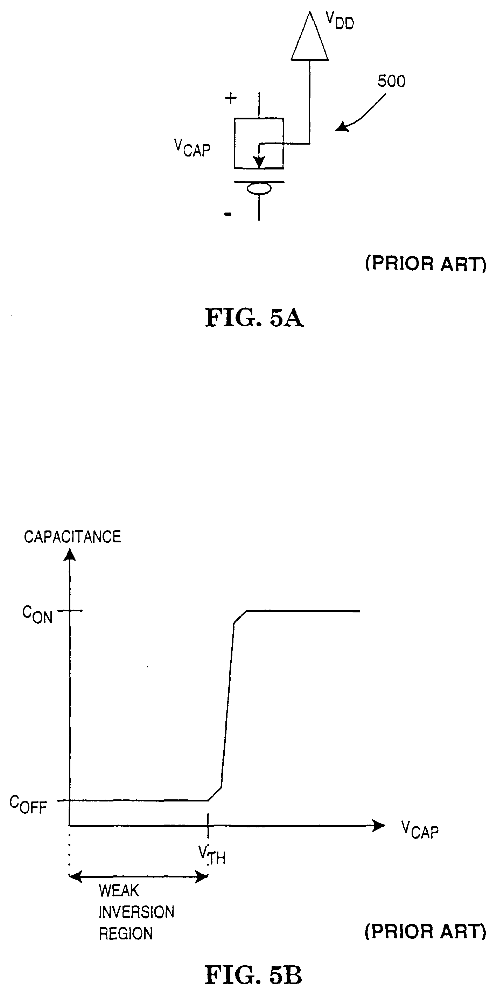

FIG. 5A shows a metal-oxide semiconductor field effect transistor (MOSFET) 500 with its drain and source terminals connected together to form one terminal of a non-linear variable capacitor. The gate terminal of the MOSFET forms the other terminal of the varactor. The capacitance of varactor 500 is a function of the voltage $V_{CAP}$ applied across the terminals of the varactor. FIG. 5B illustrates the non-linear relationship of the capacitance of varactor 500 as a function of $V_{CAP}$ Below the threshold voltage $V_{TH}$ of varactor 500, $V_{CAP} < V_{TH}$, varactor 500 is in a weak inversion region or a depletion region of its function and has a small capacitance $C_{OFF}$ Above threshold $V_{TH}$, $V_{CAP} > V_{TH}$, varactor 500 is in its active region and the capacitance of the varactor jumps to $C_{ON}$.

The values of $C_{ON}$ and $C_{OFF}$ are determined by the are of the MOSFET gate. A typical ratio of $C_{ON}$ to $C_{OFF}$ is 10:1 with a typical value for $C_{ON}$ in an oscillator being 2 picofarads (pF) and a typical value of $C_{OFF}$ being 0.2 pF.

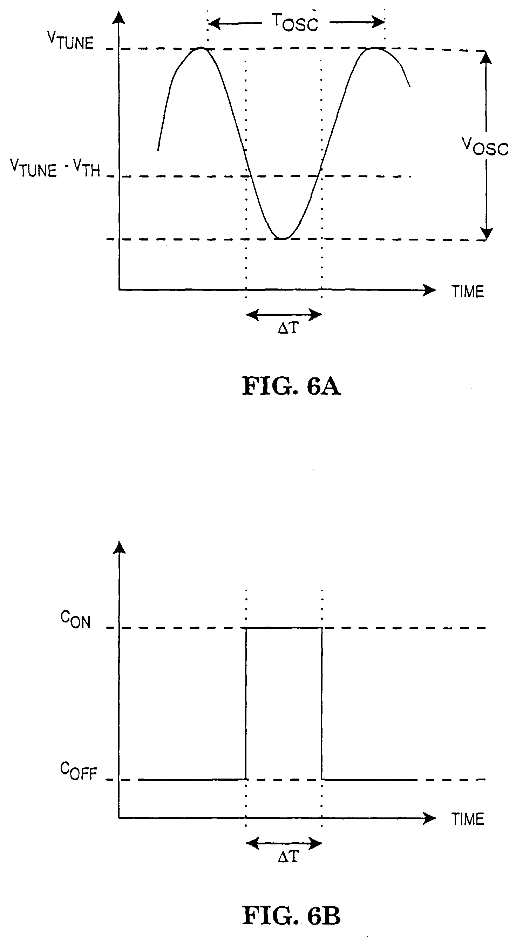

The variable capacitance characteristic of MOSFET devices is typically a problem when fabricating circuits using MOS processes. However, in the present invention, this characteristic is exploited to use the MOSFET device as a varactor which FIGS. 6A and 6B help illustrate.

FIG 6A illustrates the effect of the $V_{TUNE}$, the TUNE voltage signal applied to the varactor 500 of FIG. 5A. $V_{TUNE}$ is an analog signal typically generated within devices such as phase-locked loops to drive a voltage controlled oscillator. An oscillating voltage waveform, such as that generated in an oscillator circuit, oscillating over voltage range $V_{OSC}$ relative to tuning voltage $V_{TUNE}$ will drop below the voltage level $V_{TUNE} - V_{TH}$ for a time interval ÄT. This will cause varactor 500 to become active thus raising the capacitance of the varactor to $C_{ON}$ for the interval ÄT, which is farther illustrated in FIG. 6B. The effective capacitance $C_{EFF}$ of varactor 500 over a period $T_{OSC}$ of the oscillating waveform of FIG. 6A can be approximately stated as $C_{EFF} \_ ÄT/T_{OSC}$. The amount of time that varactor 500 is in its active region can be varied by adjusting $V_{TUNE}$ in order to change , i.e. an increase in $V_{TUNE}$ decreases $ÄT/T_{OSC}$

and a decrease in $V_{TUNE}$ will increase $ÄT/T_{OSC}$. Note that the oscillating waveform of FIG. 6A is not a perfect sinusoid in that its shape will be affected by the change in capacitance of varactor 500.

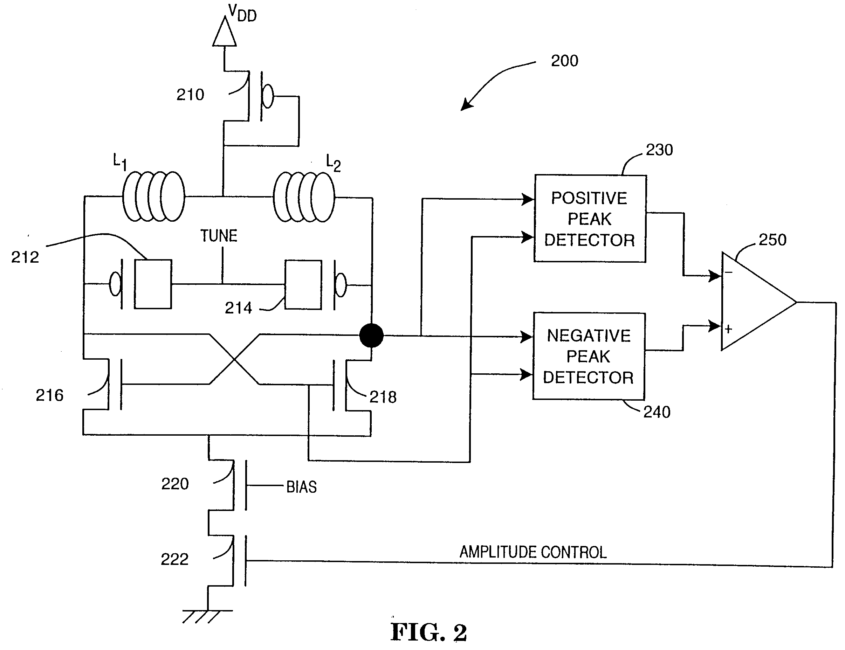

Referring now to FIG. 2, an embodiment of an NMOS oscillator 200, according to the present invention, which includes a pair of MOSFET varactors 212 and 214, as described above with regard to varactor 500 of FIG. 5A. NMOS transistors 216 and 218 are interconnected to form a differential amplifier. The source terminals of transistors 216 and 218 are connected to the drain terminal of transistor 220. Transistor 220 is driven by a biasing signal, applied to the BIAS terminal, which combines with transistor 222, driven by the AMPLITUDE CONTROL signal, to form a cascoded current source which determines the combined source current of the differential amplifier formed by transistors 216 and 218. The drain terminal of transistor 216 is coupled to the gate terminal of varactor 212 and to one terminal of inductor $L_1$. Similarly, transistor 218 is coupled to the gate terminal of varactor 214 and to one terminal of inductor $L_2$. The other terminals of inductors $L_1$ and $L_2$ are both tied to the drain terminal of diode-connected transistor 210 which is also coupled to the supply voltage $V_{DD}$. Transistor 210 combines with the cascoded current source formed by transistors 220 and 222 to set the common-mode voltage of the differential amplifier outputs (the drain terminals of transistors 216 and 218) in between the power supply voltage $V_{DD}$ and the ground potential. The commonly connected source and drain terminals of varactors 212 and 214 are connected to a TUNE terminal to which the tuning voltage signal $V_{TUNE}$ is applied in order to control the variable capacitance of varactors 212 and 214.

The oscillation amplitude of the oscillating waveform of FIG. 6A must be controlled in order to obtain a predictable $ÄT/T_{OSC}$ ratio. To control the oscillation amplitude, the envelope of the oscillation is detected by positive peak detector 230 and negative peak detector 240 and amplified by amplifier 250. Both positive peak detector 230 and negative peak detector 240 have two input terminals, one of each connected to the drain terminal of transistor 218 and an other of each connected to the drain terminal of transistor 216. The output terminal of positive peak detector 230 is coupled to the negative input of amplifier 250 and the output terminal of negative peak detector 240 is coupled to the positive input of amplifier 250 in order to form a negative feedback loop. Amplifier 250 generates the AMPLITUDE CONTROL signal that drives transistor 222 in order to control the combined source current of the differential amplifier formed by transistors 216 and 218 and, therefore, the gain of the differential amplifier.

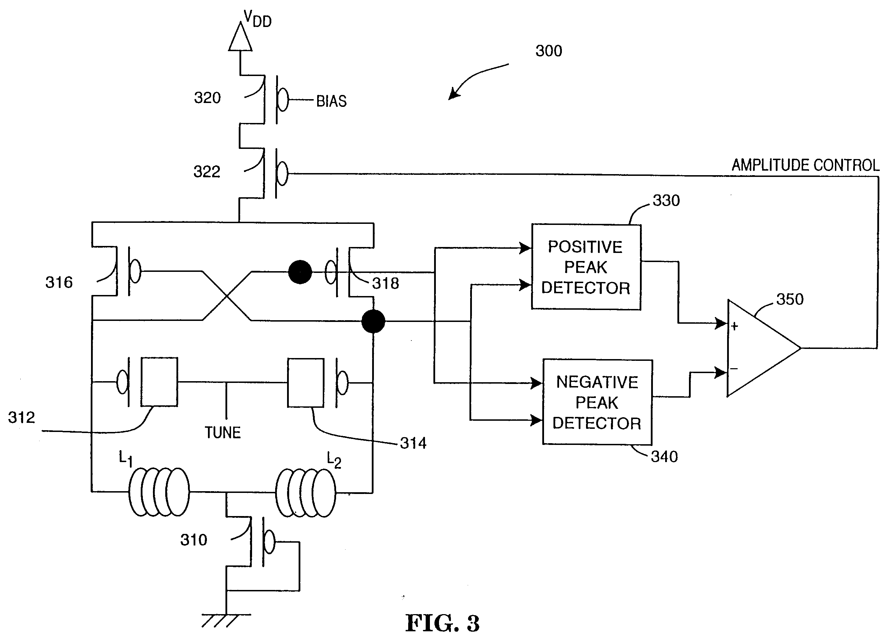

FIG. 3 shows an embodiment of a PMOS oscillator 300 according to the present invention. PMOS transistors 316 and 318 are cross connected to form a differential amplifier. The drain terminals of transistors 316 and 318 are connected to the source terminal of transistor 322. Transistor 322, under control of the AMPLITUDE CONTROL signal, combines with transistor 320, driven by the biasing signal applied to the BIAS terminal, to establish the combined drain current for transistors 316 and 318.

The source terminal of transistor 316 is connected to the gate terminal of varactor 312 and one terminal of inductor $L_1$. Similarly, the source terminal of transistor 318 is connected to the gate terminal of varactor 314 and one terminal of inductor $L_2$. The other terminal of each of inductors $L_1$ and $L_2$ is connected to the drain of diode-connected transistor 310. The commonly connected drain and source terminals of both varactors 312 and 314 are connected to the TUNE terminal which receives the $V_{TUNE}$ voltage signal which controls the effective capacitance of the varactors.

Just as in NMOS oscillator 200, the amplitude of the oscillating waveform must be controlled which is accomplished through the AMPLITUDE CONTROL signal. Positive and negative peak detectors 330 and 340 each have two input terminals, one input terminal being connected to the drain terminal of transistor 316 and the other terminal being coupled to the drain terminal of transistor 318. However, the output terminal of positive peak detector 330 is coupled to the positive input of amplifier 350 while the output terminal of negative peak detector 330 is coupled to the negative input of amplifier 350 to obtain the proper polarity for a negative feedback loop in a PMOS configuration. Amplifier 350 then generates the AMPLITUDE CONTROL signal to modulate the combined drain current of the differential amplifier formed by transistors 316 and 318 in order to control the amplitude of the amplifier.

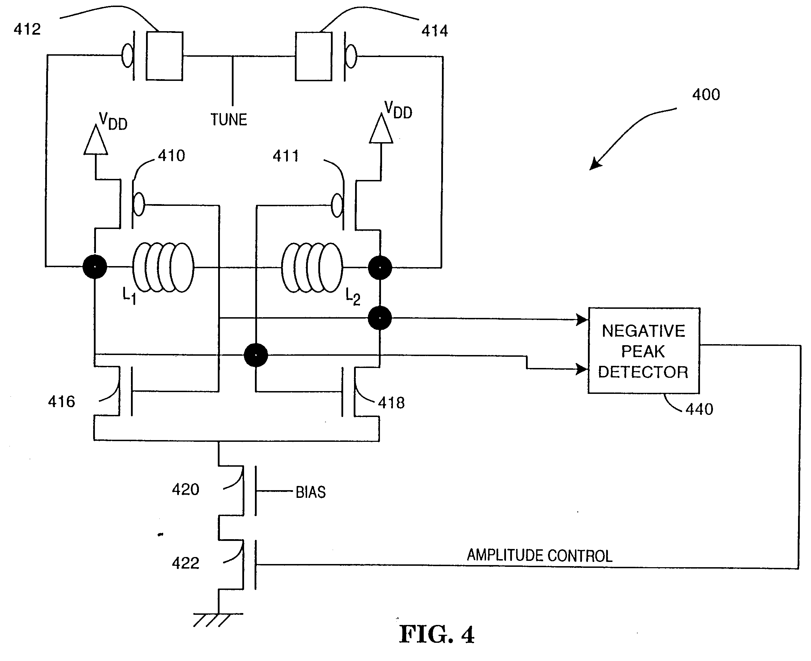

An embodiment of a fully complementary MOS (CMOS) oscillator 400 is shown in FIG. 4. PMOS transistor 410 is connected in series with NMOS transistor 416 and PMOS transistor 411 is connected in series with NMOS transistor 418. The gate terminals of transistors 410 and 416 are connected to the common source and drain terminal connection of transistors 411 and 418 and the gate terminals of transistors 411 and 418 are connected to the common source and drain terminal connection of transistors 410 and 416 in order to form a complementary differential amplifier. Inductors L1 and L2 are connected in series with one another between the common source and drain terminals of transistor pair 410 and 416 and transistor pair 411 and 418 as are varactors 412 and 414, the common source and drain connections of both varactors 412 and 414 are connected to the TUNE terminal to which $V_{TUNE}$ is applied.

Due to the fully complementary nature of the differential amplifier formed by transistors 410, 416, 411 and 418, only negative peak detector 440 is needed to detect the envelope of the oscillation in order to generate the AMPLITUDE CONTROL signal. The AMPLITUDE CONTROL signal drives transistor 422 which is connected in series with transistor 420, driven by the biasing signal applied to the BIAS, to determine the combined source current of the differential amplifier and, therefore, the amplifier gain.

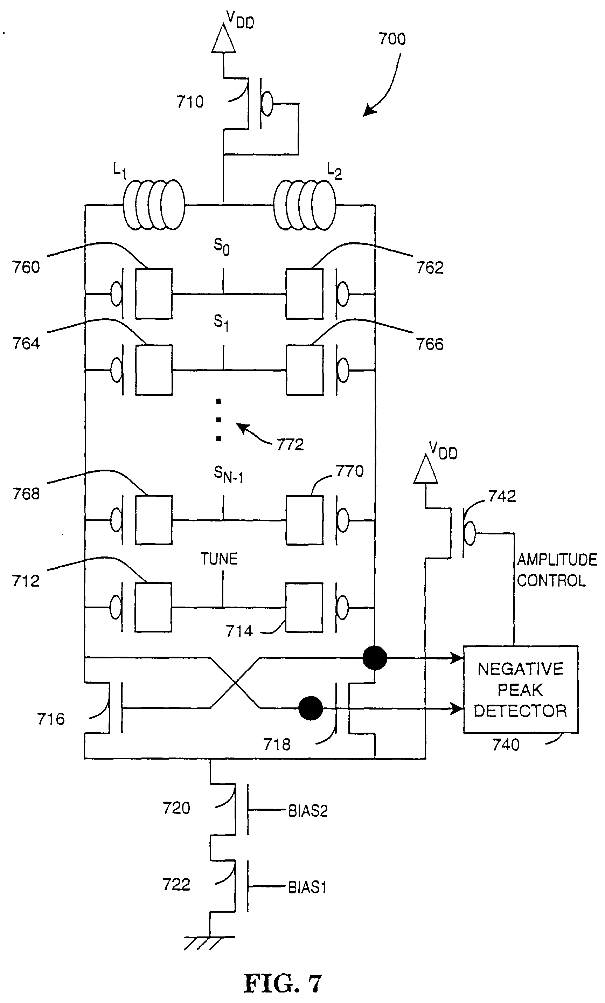

FIG. 7 is a circuit diagram of an embodiment of an oscillator 700, according to the present invention, having multiple MOSFET varactors for selecting a capacitance range of the oscillator 700.

Oscillator 700 includes a series of varactor pairs, which are driven by set signal values applied to terminals $S_0$-$S_{N-1}$, in order to establish a fixed capacitance in addition to the variable capacitance produced by varactors 712 and 714 which are driven by the tuning voltage signal applied to the TUNE terminal. Varactors 760 and 762 are connected in series with each other between the output terminals of the differential amplifier, i.e. the drain terminals of transistors 716 and 718. The commonly connected source and drain terminals of varactors 760 and 762 are connected to terminal $S_0$ which is driven by a set voltage level that either turns varactors 760 and 762 on, placing the varactors in their active regions and at their high capacitance value $C_{ON}$, or off placing the varactors in their weak inversion region or depletion region and at their low capacitance value $C_{OFF}$. Varactors 764 and 766 form another varactor pair that is similarly connected to terminal $S_1$. Varactors 768 and 770 form another varactor pair that is similarly connected to terminal $S_{N-1}$. Ellipses 772 indicate that the number of varactor pairs can be varied to suit the requirements of a specific application.

Similar to oscillators 200, 300 and 400, oscillator 700 includes an automatic gain control circuit in the form of negative peak detector 740 which has two input terminals, one of which is connected to the drain terminal of transistor 716, which is one output of the differential amplifier, and the other of which is connected to the drain terminal of transistor 718, which is the other output of the differential amplifier. Transistors 720, driven by a first biasing signal applied to terminal BIAS1, and 722, driven by a second biasing signal applied to terminal BIAS2, establish a fixed amount of current flowing from the drain terminal of transistor 720, which is connected to the source terminals of transistors 716 and 718, to ground. The output of the negative peak detector 740 drives transistor 742, which is also connected to the drain terminal of transistor 720, thereby modulating the amount of current sourced by transistor 742 and which the drain terminal of transistor 720 must sink. This determines the amount of combined source current available at the drain terminal of transistor 720 for signal variation in transistors 716 and 718 and thereby controls the gain of the amplifier.

A set of signals applied to terminals $S_0$-$S_{N-1}$ turn the corresponding varactors on or off in order to obtain a controlled, relatively fixed, capacitance value in addition to the variable capacitance value produced by the signal applied to the TUNE terminal. For instance, one minimum capacitance value for the oscillator 700 can be established by applying a voltage above the threshold voltage for varactors 760 and 762 to $S_0$ to obtain $C_{ON}$, as illustrated in FIG. 5B, from each of the varactors 760 and 762 while $S_1$-$S_{N-1}$ receive voltage values below threshold such that varactors 764, 766, 768 and 770 yield $C_{OFF}$. The $V_{TUNE}$ signal applied to the TUNE terminal is then used to fine tune the capacitance for the specific application. The tuning range required of the $V_{TUNE}$ signal can consequently be reduced because of the contribution of the capacitance controllable via the $S_0$-$S_{N-1}$ terminals. Along the same lines, varying the number of varactor pairs N and the values of the signals driving the corresponding terminals $S_0$-$S_{N-1}$ permits oscillator 700 to be adapted to a variety of overlapping operating frequency ranges with lower amplifier gain requirements in order to reduce the noise injection effects that occur at the TUNE terminal.

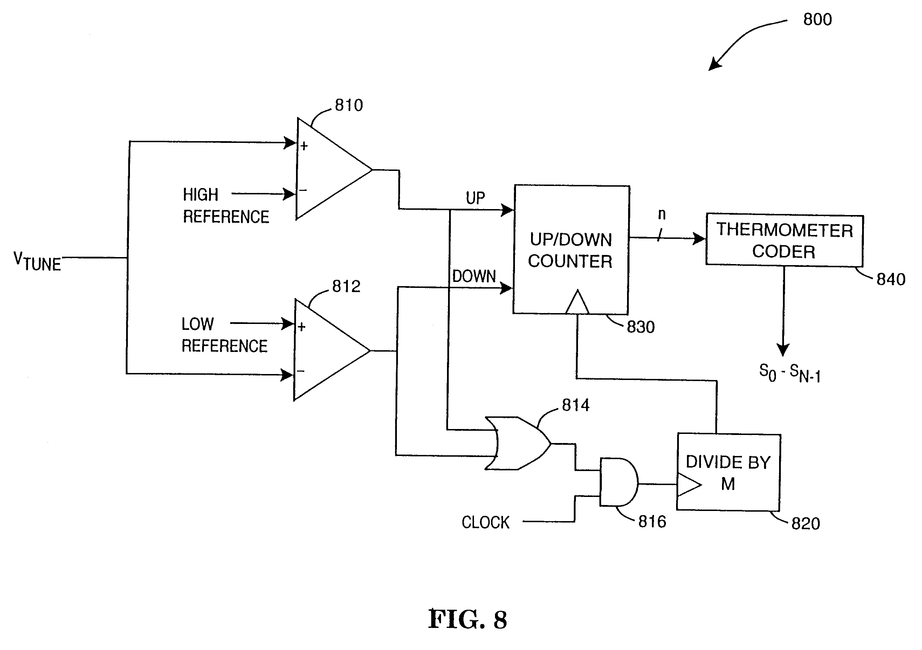

In FIG. 8, a range select circuit 800 is shown which is suitable for use in generating the signals which drive terminals $S_0$-$S_{N-1}$ of oscillator 700 in FIG. 7. The voltage signal $V_{TUNE}$ applied to the TUNE terminal of oscillator 700 is input to comparators 810 and 812 wherein $V_{TUNE}$ is compared to a HIGH REFERENCE voltage and a LOW REFERENCE voltage, respectively. The output of comparator 810 is input as an UP signal to up/down counter 830 and to one input of OR gate 814. The output of comparator 812 is input as a DOWN signal to up/down counter 830 and to another input of OR gate 814.

When $V_{TUNE}$ is outside of a voltage range defined by the HIGH REFERENCE and LOW REFERENCE voltages then the output of OR gate 814 will transition to a high logic value and enable a CLOCK signal through AND gate 816 to clock divider 820 which divides the CLOCK signal by a predetermined number M. The divided CLOCK signal output from divider 820 drives the clock input of up/down counter 830. When $V_{TUNE}$ is out-of-range above HIGH REFERENCE, then up/down counter 830 will count up. Conversely, when $V_{TUNE}$ is out-of-range below LOW REFERENCE, then up/down counter 830 will count down. The resulting count in up/down counter 830 is output as n bits of data to thermometer coder 840. Thermometer encoder 840 translates the count into a number of logical one signals corresponding to the count which are applied to range selection terminals $S_0$-$S_{N-1}$ of oscillator 700 to bring the oscillation frequency of the oscillator back into the range determined by the high and low reference signals and therefore adjust the oscillation frequency for temperature and process variations.

The oscillators with MOSFET varactors, according to the present invention and described above, are able to obtain the oscillator function with low intrinsic noise and with an oscillation frequency that is stable over a range of operating frequencies, fabrication processes, supply voltage levels and temperature.

Having described and illustrated the principles of the invention in a preferred embodiment thereof, it should be apparent that the invention can be modified in arrangement and detail without departing from such principles. We claim all modifications and variation coming within the spirit and scope of the following claims.

**Claims**

1. An oscillator circuit (200) the circuit comprising:

    a differential amplifier (216, 218) having first and second signal terminals and a current terminal;
    a current source (222) coupled between the current terminal of the differential amplifier and a first power supply terminal ($V_{DD}$) and configured to conduct a control current;
    first ($L_1$) and second ($L_2$) inductors coupled in series with one another between the first and second signal terminals of the differential amplifier;
    first (212) and second (214) MOSFET varactors coupled in series with one another to form a first pair of varactors, wherein the first pair of MOSFET varactors is coupled between the first and second signal terminals of the differential amplifier, and farther wherein a common node of the first pair of varactors is coupled to a tune terminal (TUNE).

2. The oscillator circuit of claim 1, farther including a diode-(210) connected transistor coupled between a second power supply terminal and a common node of the first and second inductors.

3. The oscillator circuit of claim 1, further including:

    an automatic gain control circuit (230, 240, 250) having first and second inputs, wherein the first input of the automatic gain control circuit is coupled to the first signal terminal of the differential amplifier (216, 218) and the second input of the automatic gain control circuit is coupled to the second signal terminal of the differential amplifier, and farther wherein the automatic gain control circuit is farther configured to generate an amplitude control signal responsive to a signal received at the first and second inputs of the automatic gain control circuit; and wherein the current source (222) is further configured to receive the amplitude control signal and, responsive thereto, modulate the control current so as to adjust a gain of the differential amplifier.

4. The oscillator of claim 1, further including:

    third (760) and fourth (762) MOSFET varactors coupled in series with one another to form a second pair of MOSFET varactors, wherein the second pair of MOSFET varactors is coupled between the first and second signal terminals of the differential amplifier, and wherein a common node of the third and fourth MOSFET varactors is coupled to a first set capacitance control terminal ($S_0$).

5. The oscillator of claim 1, further including:

    a plurality of set capacitance control terminals ($S_0$, $S_1$, $S_{N-1}$); and
    a plurality of MOSFET varactor pairs (760, 762, 764, 766, 768, 770), wherein each one of the plurality of MOSFET varactor pairs is coupled between the first and second signal terminals of the differential amplifier, and further wherein each one of the plurality of MOSFET varactor pairs has a common node which is coupled to a corresponding one of the plurality of set capacitance control terminals.

6. The oscillator of claim 5, further including:

    a range selecting circuit (800) having an input and a plurality of output terminals, wherein the input terminal of the range selecting circuit is coupled to the tuning terminal (TUNE) and each one of the plurality of output terminals is coupled to a corresponding one of the plurality of set capacitance control terminals ($S_0$, $S_1$, $S_{N-1}$), the range selecting circuit being configured to receive a high reference voltage (HIGH REFERENCE), a low reference voltage (LOW REFERENCE) and a clock signal (CLOCK) and, responsive to the signal received at the tuning terminal, generate a capacitance control signal at the plurality of output terminals of the range selecting circuit.

7. The oscillator of claim 1, further including an n-well disposed adjacent the first ($L_1$) and second ($L_2$) inductors and coupled to one of the first and second power supply terminals.

8. The oscillator of claim 1, wherein the first (212) and second (214) MOSFET varactors are each further comprised of a MOSFET transistor having drain, source and gate terminals, wherein the source and drain terminals are coupled to one another to form a terminal of the MOSFET varactor and the gate terminal of the MOSFET transistor forms another terminal of the MOSFET varactor.

9. The oscillator of claim 1, wherein the first ($L_1$) and second ($L_2$) inductors are each comprised of integrated silicon devices.

FIG. 1A

(PRIOR ART)

(PRIOR ART)

# FIG. 1B

**FIG. 2**

EP 0 899 866 A1

FIG. 3

FIG. 4

(PRIOR ART)

**FIG. 5A**

(PRIOR ART)

**FIG. 5B**

$V_{TUNE}$

$T_{OSC}$

$V_{OSC}$

$V_{TUNE} - V_{TH}$

TIME

$\Delta T$

**FIG. 6A**

$c_{ON}$

$c_{OFF}$

TIME

$\Delta T$

**FIG. 6B**

**FIG. 7**

EP 0 899 866 A1

FIG. 8

## EUROPEAN SEARCH REPORT

**European Patent Office**

Application Number

EP 98 11 5451

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| Y | TOSHIHIKO KANEKO ET AL: "A KU BAND CONVERTER IC" INTERNATIONAL MICROWAVE SYMPOSIUM DIGEST (MTT-S), ALBUQUERQUE, JUNE 1 - 5, 1992, vol. 1, 1 June 1992, pages 451-454, XP000332753 REID D W * page 452, column 1, line 1 - line 18; figure 3 * | 1 | H03B5/12 |
| Y | US 5 483 207 A (GABARA THADDEUS J) 9 January 1996 * column 3, line 2 - column 4, line 2; figure 2A * | 1 | |
| A | BAUMBERGER W ET AL: "A GAAS SINGLE CHIP 2.4 GHZ PLL FREQUENCY MULTIPLIER" IEEE 1996 MICROWAVE AND MILLIMETER-WAVE MONOLITHIC CIRCUITS SYMPOSIUM. DIGEST OF PAPERS, SAN FRANCISCO, JUNE 16 - 19, 1996, 1996, pages 39-42, XP000683190 BAHL I J (ED ) * page 40, column 1, line 9 - line 24; figure 2 * | 1 | |
| A | CH 682 019 A (CROSSMOS S A;CLAUDE ERIC JAQUET) 30 June 1993 * column 2, line 51 - column 3, line 21; figure 3 * | 3 | TECHNICAL FIELDS SEARCHED (Int.Cl.6) H03B H03L H03K |
| A,D | CRANINCKX J ET AL: "A 1.8-GHZ LOW-PHASE-NOISE CMOS VCO USING OPTIMIZED HOLLOW SPIRAL INDUCTORS" IEEE JOURNAL OF SOLID-STATE CIRCUITS, vol. 32, no. 5, May 1997, pages 736-744, XP000698793 | 1 | |

The present search report has been drawn up for all claims

| Place of search | Date of completion of the search | Examiner |
|---|---|---|
| THE HAGUE | 16 November 1998 | Dhondt, I |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)